Europäisches Patentamt

European Patent Office

Office européen des brevets

(19)

(11) Publication number: **0 025 667**
**B1**

(12) **EUROPEAN PATENT SPECIFICATION**

(45) Date of publication of patent specification: **27.08.86**

(51) Int. Cl.⁴: **H 03 K 19/088, H 01 L 27/06**

(21) Application number: **80303074.1**

(22) Date of filing: **03.09.80**

(54) Logic circuit device.

(30) Priority: **07.09.79 JP 114999/79**

(43) Date of publication of application:
**25.03.81 Bulletin 81/12**

(45) Publication of the grant of the patent:
**27.08.86 Bulletin 86/35**

(84) Designated Contracting States:
**DE FR GB NL**

(56) References cited:

**IBM TECHNICAL DISCLOSURE BULLETIN, vol. 19, no. 1 June 1976, pages 142-143, New York (USA); H.H.BERGER et al.: "TTL circuit with improved noise margins"**

**ELECTRONIQUE INDUSTRIELLE, no. 125, July/August 1969, pages 484-487; "Panorama des circuits intégrés numériques"**

**IBM TECHNICAL DISCLOSURE BULLETIN, vol. 18, no. 11, April 1976, pages 3639-3640, New York (USA); A.J.GRUODIS et al.: "Diode transistor logic feedback circuit"**

**COMPUTER DESIGN, vol. 11, no. 10, October 1972, pages 79-86; T.E.MILES: "Schottky TTL vs ECL for high speed logic"**

(73) Proprietor: **FUJITSU LIMITED
1015, Kamikodanaka Nakahara-ku
Kawasaki-shi Kanagawa 211 (JP)**

(72) Inventor: **Higashi, Norikuni
8-6-17-301, Arima Takatsu-ku
Kawasaki-shi Kanagawa 213 (JP)**

(74) Representative: **Massey, Alexander et al
MARKS & CLERK Suite 301 Sunlight House Quay Street
Manchester, M3 3JY (GB)**

Courier Press, Leamington Spa, England.

## Description

Field of the invention

The present invention relates to a logic circuit device which has a multi-emitter transistor as an input stage and which is manufactured as a large scale integrated circuit.

Background of the invention

A large scale integrated circuit includes a great number of circuit elements in a very small space. Therefore, the process for manufacturing a large scale integration circuit is very complex and requires a large amount of time. Recently, a process called the master slice method has been developed. In the master slice method, the processes before the formation of wiring by a metallic evaporation process are commonly carried out to many circuits and only a final process, such as an aluminium evaporation process, is different depending on the circuit to be formed.

One example of a transistor-transistor logic (hereinafter called TTL) circuit which is manufactured by the master slice method is disclosed in an article entitled "TTL 500-gate Master Slice LSI (MB 15000 Series)", by Norikuni Higashi et al, Fujitsu, Vol. 30, No. 1 pp 185~208. In the TTL circuit disclosed in the article, a multi-emitter transistor is used as the input stage. In this TTL circuit, when at least one of the input levels of the multi-emitter transistor becomes low as a result of receiving an input logic signal, the multi-emitter transistor is placed in a conductive state and a large current flows in a collector of the multi-emitter transistor, so that a large emitter current of the multi-emitter transistor flows.

Therefore, in the master slice method, when the master slice having many gates, such as more than 500 gates is manufactured by using a conventional TTL, and when the input level becomes low, a voltage drop in an input wiring portion which is connected to the emitter becomes large due to the large emitter current of the multi-emitter transistor. Further, usually, as 0.35 V is used as a low level logic input and more than 1 V is used as a high level logic input, about 0.65 V be used as a threshold voltage. However, if a voltage drop in the input wiring portion is large, the difference between the low input level of the logic circuit and the threshold voltage becomes small, so that a margin of the low level of the logic circuit to the threshold voltage decreases.

IBM Technical Disclosure Bulletin, Vol. 19, No. 1, June 1976, pages 142—143 discloses a TTL circuit with improved noise margins. This circuit comprises an input NPN transistor having a plurality of emitters to which input signals are applied and an output NPN transistor the base of which is connected to the collector of the input transistor. The base of a further PNP transistor is also connected to the collector of the input transistor, the emitter of the further transistor being connected to the base of the input transistor. The further transistor is complementary to the input transistor and reduces the effective inverse current amplification of the input transistor, the further transistor discharging a large part of the parasitic current which would otherwise flow through the input transistor emitter. This arrangement is thus similar to that described in the above-mentioned disclosure by Norikuni Higashi et al with the addition of a further transistor to modify the effective characteristics of the input transistor.

An object of the present invention is to provide an improved logic circuit device.

According to the present invention there is provided a logic circuit device comprising an NPN input transistor (Q11) having a plurality of first terminals and a second terminal, each of the first terminals being connected to one of a plurality of input terminals (1-n) of the logic circuit device, a PNP transistor (Q12) having a base connected to the said second terminal of the input transistor, an emitter connected to a first electric power supply potential and a collector connected to a second power supply potential, and an NPN output transistor (Q13) having an emitter connected to the said second power supply potential and a base connected to the said second terminal of the NPN input transistor, characterised in that a level shift means (D1) is connected between the emitter of the PNP transistor (Q12) and the base of the NPN output transistor (Q13).

Further features and advantages of the present invention will be apparent from the ensuing description with reference to the accompanying drawings to which, however, the scope of the invention is in no way limited.

Fig. 1 is one example of a circuit of a conventional logic circuit device;

Fig. 2 is one embodiment of a circuit of a logic circuit device according to the present invention;

Fig. 3A is a cross sectional view of a multi-emitter transistor used in the circuit illustrated in Fig. 2, Fig. 3B is an equivalent circuit of the multi-emitter transistor illustrated in Fig. 3A; and

Fig. 4 is another embodiment of a circuit of the logic circuit device according to the present invention.

Detailed explanation of the invention

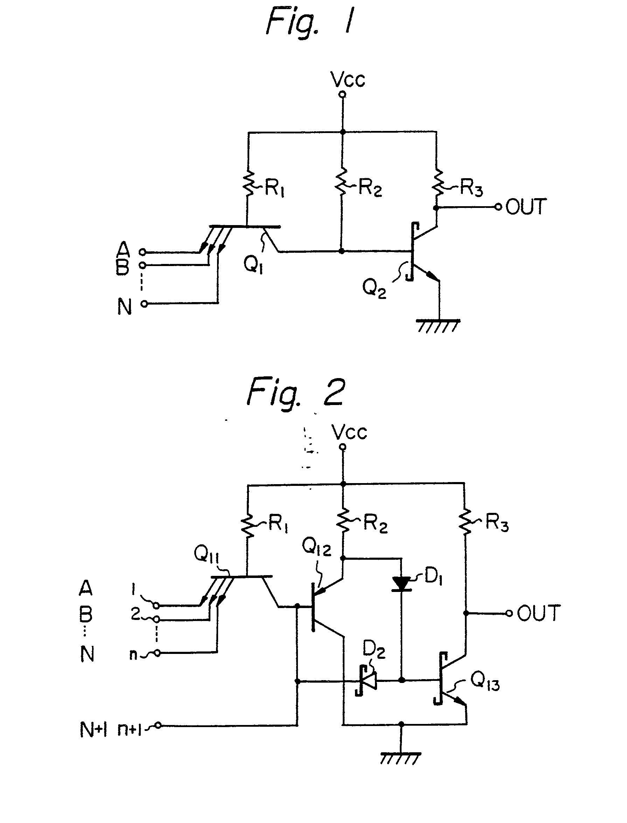

Referring to Fig. 1, a conventional TTL circuit includes a multi-emitter transistor $Q_1$ having emitters connected to input terminals receiving inputs A—N, an output transistor having a collector connected to an output terminal, resistors $R_1$, $R_2$, $R_3$ which are connected between an electric source and a base of the multi-emitter transistor, a connection point of the collector of the multi-emitter transistor and a base of the output transistor, and the collector of the output transistor, respectively.

In the conventional TTL circuit illustrated in Fig. 1, if the logic level of at least one input A, B, . . . , N becomes low, the transistor $Q_1$ is placed in a conductive state and a large collector current flows in the transistor $Q_1$ via the resistor $R_2$, so

that a large current flows in the emitter of the transistor $Q_1$.

Therefore, if a master slice having many gates, such as, more than 500 gates is manufactured by using a conventional TTL structure as illustrated in Fig. 1, when the input level becomes low, a voltage drop in an input wiring portion which is connected to the emitter becomes large due to the large emitter current of the multi-emitter transistor $Q_1$. Further, usually 0.35 V is used as a low level logic input and more than 1 V is used as a high level logic input, therefore, it is desired that about 0.65 V be used as a threshold voltage. However, if the voltage drop in the input wiring portion is large, the difference between the low level input level of the logic circuit and the threshold voltage becomes small, so that the margin of the low level of the logic circuit to the threshold voltage decreases.

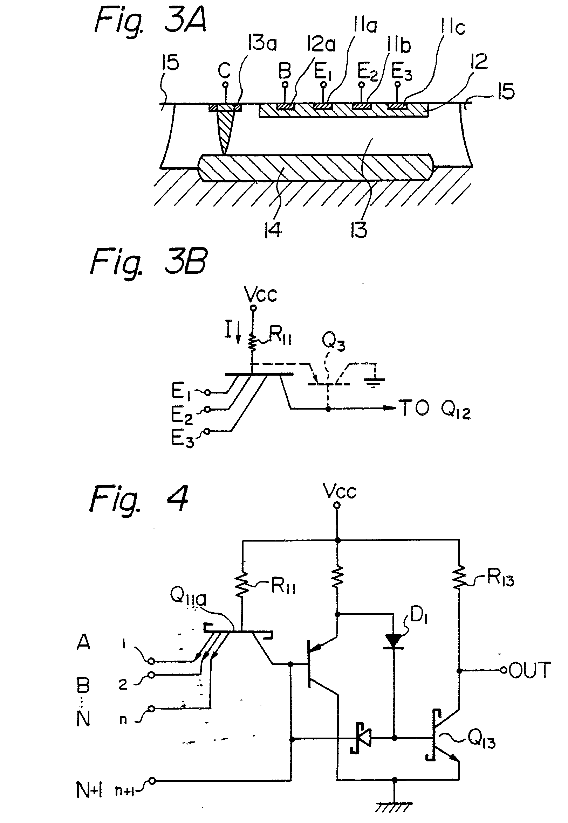

Fig. 2 illustrates a circuit of one embodiment of a multi-input logic circuit according to the present invention. Referring to Fig. 2, input signals A, B, ..., N are applied to input terminals 1, 2, ..., n which are connected to emitters of an NPN type multi-emitter transistor $Q_{11}$, a base of the multi-emitter transistor $Q_{11}$ is connected via a resistor $R_1$ to a first electric power supply potential in the form of electric source $V_{CC}$, and a collector of the multi-emitter transistor $Q_{11}$ is connected to a base of PNP type transistor $Q_{12}$. An emitter of the transistor $Q_{12}$ is connected via a resistor $R_{12}$ to the electric source $V_{CC}$ and the collector thereof is connected to a second electric power supply potential, in this case ground. The emitter of the transistor $Q_{12}$ is connected to an anode of the diode $D_1$, which is used as a level shift element, and a cathode of the diode $D_1$ is connected to a base of a transistor $Q_{13}$ having an emitter which is connected to ground, so that the diode $D_1$ and a base-emitter junction of the transistor $Q_{13}$ are connected in series between the electric souce $V_{CC}$ and ground. A collector of the transistor $Q_{13}$ is connected via a resistor $R_{13}$ to the electric source $V_{CC}$ and, also, said collector is connected to an output terminal OUT. The base of the transistor $Q_{13}$ is also connected to an anode of a Schottky barrier diode $D_2$, and a cathode of the diode $D_2$ is connected to the base of the transistor $Q_{12}$ and the collector of the transistor $Q_{11}$.

In the circuit illustrated in Fig. 2, if at least one of the inputs A, B, ..., N becomes low, a base current flows through the transistor $Q_{11}$ and the transistor $Q_{11}$ is placed in a conductive state, and in this case, a collector current of the transistor $Q_{11}$ is supplied via the base of the transistor $Q_{12}$. The base current of the transistor $Q_{12}$ is $1/\beta(Q_{12})$ of the emitter current $I_E(Q_{12})$ of the transistor $Q_{12}$, where $\beta(Q_{12})$ is a current amplification factor of the transistor $Q_{12}$ and the value of the $\beta(Q_{12})$ is about 10. Further, a base current $I_B(Q_{11})$ of the transistor $Q_{11}$ is $1/\beta(Q_{11})$ of a collector current of the transistor $Q_{11}$, that is, a base current

$$\frac{I_E(Q_{12})}{\beta(Q_{12})}$$

of the transistor $Q_{12}$, where $\beta(Q_{11})$ is a current amplification factor of the transistor $Q_{11}$ and the value of the $(Q_{11})$ is about several tens. Therefore, a very small current $I_B(Q_{11})$, which is given by following equation, flows through the base of the transistor $Q_{11}$

$$I_B(Q_{11}) = \frac{I_E(Q_{12})}{\beta(Q_{11}) \cdot \beta(Q_{12})}$$

As the collector current of the transistor $Q_{11}$ is $1/\beta(Q_{12})$ of the emitter current of the transistor $Q_{12}$, the emitter current of the transistor $Q_{11}$ becomes a very small value.

When at least one of the input levels A, B, ... N is low level, that is, when the transistor $Q_{11}$ is in the on state, the transistor $Q_{12}$ is also in the on state and, therefore, the emitter of the transistor $Q_{12}$ is low level, so that the transistor $Q_{13}$ is placed in the non-conductive state. Therefore, the diode $D_1$ is provided for turning off the transistor $Q_{13}$ when the transistor $Q_{12}$ is in the on state and for turning on the transistor $Q_{13}$ when the transistor $Q_{12}$ is in the off state. When the transistor $Q_{13}$ is in the non-conductive state, the output terminal OUT becomes high level. When all inputs A, B, ... C are high, the transistor $Q_{11}$ is placed in the non-conductive state, and the transistor $Q_{12}$ is also in the non-conductive state and, therefore, the level of the base of the transistor $Q_{13}$ becomes high via the resistor $R_{12}$ and the diode $D_1$, so that the output terminal OUT of the transistor $Q_{13}$ becomes low level. That is, the multi-input logic circuit illustrated in Fig. 2 is operated as a positive logic NAND gate circuit. Further, the charges which are stored in the base of the transistor $Q_{13}$ when the transistor $Q_{11}$ is off and the transistor $Q_{13}$ is on are discharged to the transistor $Q_{11}$ by the Schottky barrier diode $D_2$ when the transistor $Q_{11}$ is placed in the conductive state, so that the transistor $Q_{13}$ is rapidly placed in the non-conductive state.

As mentioned above, according to the present invention, when at least one of the logic inputs A and B is low level, the emitter current of the transistor $Q_{11}$ is small, so that the voltage drop between the logic input terminals and the emitters of the transistor $Q_{11}$ is small. Therefore, the threshold voltage with respect to the low level logic input does not become small, so that the margin of the threshold voltage can be improved.

Further, according to the embodiment shown in Fig. 2, an input terminal n+1 which receives a logic input N+1 can be connected to the base of the transistor $Q_{12}$. When the logic input N+1 is low level, even if the logic inputs A, B ..., N are high level, the base current, which is $1/\beta(Q_{12})$ of

the emitter current $I_E(Q_{12})$ of the transistor $Q_{12}$, flows through the input terminal n+1, so that the transistor $Q_{13}$ is placed in the non-conductive state and a high level appears at the output terminal OUT. When all logic inputs A, B, ... N and N+1 are high level, the transistor $Q_{12}$ is non-conductive and the transistor $Q_{13}$ is conductive, so that a low level appears at the output terminal OUT. Therefore, the embodiment illustrated in Fig. 2 operates as the NAND gate also with respect to the inputs A, B, ... N and N+1.

A threshold voltage to each input terminal of the circuit illustrated in Fig. 2 can be obtained as illustrated below.

When we assume that $V_{BE}(Q_{13})$ denotes the voltage between the base and the emitter of the transistor $Q_{13}$, $V_F(D_1)$ denotes the forward voltage drop of the diode $D_1$, $V_{BE}(Q_{12})$ denotes the voltage between the base and the emitter of the transistor $Q_{12}$, $V_{CES}(Q_{11})$ denotes the voltage between the collector and the emitter of the transistor $Q_{11}$, the threshold voltage $V_{th}(n+1)$ in the terminal n+1 can be obtained by the following equation.

$$V_{th}(n+1)=V_{BE}(Q_{13})+V_F(D_1)-V_{BE}(Q_{12})$$

wherein, as
$$V_{BE}(Q_{13})=V_F(D_1)-V_{BE}(Q_{12})$$

therefore,

$$V_{th}(n+1)=V_{BE}(Q_{13})$$

Further, the threshold voltage $V_{th}$ (1, 2, ... n) in the terminals 1 or 2 can be obtained by the following equation.

$$V_{th}(1, 2, \ldots, n)=V_{th}(n+1)-V_{CES}(Q_{11})$$

wherein

$$V_{CES}(Q_{11})=0.1 \ (V)$$

therefore

$$V_{th}(1, 2, \ldots, n)=0.75-0.1=0.65 \ V$$

As mentioned above, the threshold voltage to the input terminals (1, 2, ..., n) is different from the threshold voltage to the input terminal (n+1). That is, the threshold voltage to the terminal n+1 is larger than the threshold voltage to the terminals (1, 2 ..., n). Therefore, when the flip-flop circuit is constructed by using the circuit shown in Fig. 2, if a clock pulse signal is applied to the terminal 3, this clock pulse signal is not influenced by the noise signal introduced from the outside because the threshold voltage to the terminal 3 is high. Therefore, a stable flip-flop circuit can be constructed.

Fig. 3A is a cross section of the multi-emitter transistor $Q_{11}$ formed as an integrated circuit. In Fig. 3, 11a, 11b, 11c denote emitters, 12 denotes a base region, 12 denotes a contact of the base region 12, 13 denotes a collector region, 13a denotes a contact of the collector region 13, 14 denotes a buried layer and 15 denotes an isolation region. In the multi-emitter transistor illustrated in Fig. 3A, a parasitic lateral PNP transistor is formed by the base region 12, the collector region 13 and the isolation region 15. The equivalent circuit of parasitic PNP transistor $Q_3$ is illustrated in Fig. 3B by dotted lines. As a base cut off of the transistor $Q_{12}$ is determined by a current supplied from the resistor $R_{11}$, the current supplied to the base of the transistor $Q_{12}$ is determined by the current $I/\beta(Q_3)$. Therefore, the operation speed of the circuit decreases by the effect of the lateral transistor.

For the purpose of removing the above-mentioned drawback the following measures are recommended.

(a) A multi-emitter transistor 11a using a Schottky barrier diode is used in place of the multi-emitter transistor $Q_{11}$ as illustrated in Fig. 4. When the Schottky barrier diode is attached to the transistor $Q_{11a}$, the threshold voltage of the transistor decreases about 200 mV and a high operation speed can be obtained.

(b) The lateral PNP transistor $Q_3$ can be removed by using an oxide film without using the isolation diffusion. In this method, the high speed can be obtained without decreasing the threshold voltage.

(c) The collector of the transistor $Q_{11}$ and the base of the transistor $Q_{12}$ are the same conduction type and have an identical potential. Therefore, these transistors $Q_{11}$ and $Q_{12}$ can be formed in the same isolation, so that the construction of the integrated circuit can be small in size.

As mentioned above, according to the present invention, a small value can be used as the emitter current of the multi-emitter transistor when the logic input level is low. Therefore, the voltage drop in the wires connected to the emitter is small and the margin of the thresold voltage to the inputs can be improved.

**Claims**

1. A logic circuit device comprising an NPN input transistor (Q11) having a plurality of first terminals and a second terminal, each of the first terminals being connected to one of a plurality of input terminals (1-n) of the logic circuit device, a PNP transistor (Q12) having a base connected to the said second terminal of the input transistor, an emitter connected to a first electric power supply potential and a collector connected to a second power supply potential, and an NPN output transistor (Q13) having an emitter connected to the said second power supply potential, and a base connected to the said second terminal of the NPN input transistor, characterised in that a level shift means (D1) is connected between the emitter of the PNP transistor (Q12) and the base of the NPN output transistor (Q13).

2. A logic circuit device according to claim 1,

7    0 025 667    8

further comprising an input terminal (n+1) which is connected to said base of said PNP transistor (Q12).

3. A logic circuit device according to claim 1, wherein said NPN input transistor (Q11) is a multi-emitter transistor having a plurality of emitters for said first terminals and a collector for said second terminal.

4. A logic circuit device according to claim 3, wherein said multi-emitter transistor is formed as a Schottky barrier transistor (Q11a).

5. A logic circuit device according to claim 3, wherein both said multi-emitter transistor (Q11) and said PNP transistor (Q12) are formed in an isolation region (15).


**Patentansprüche**

1. Logische Schaltungsvorrichtung mit einem NPN - Eingangstransistor (Q11), der eine Mehrzahl von ersten Anschlüssen und einen zweiten Anschluß hat, von denen jeder erste Anschluß mit einem von einer Vielzahl von Eingangsanschlüssen (1-n) der logischen Schaltungsvorrichtung verbunden ist, einem PNP-Transistor (Q12), der eine Basis, die mit dem genannten zweiten Anschluß des Eingangstransistors verbunden ist, einen Emitter, der mit einem ersten elektrischen Energieversorgungspotential verbunden ist, und einem Kollektor, der mit einem zweiten Energieversorgungspotential verbunden ist, hat, und einem NPN - Ausgangstransistor (Q13), der einen Emitter, der mit dem genannten zweiten Energieversorgungspotential verbunden ist, und eine Basis, die mit dem genannten zweiten Anschluß des NPN - Eingangstransistors verbunden ist, hat, dadurch gekennzeichnet, daß eine Pegelverschiebungseinrichtung (D1) zwischen dem Emitter des PNP-Transistors (Q12) und der Basis des NPN - Ausgangstransistors (Q13) angeschlossen ist.

2. Logische Schaltungsvorrichtung nach Anspruch 1, ferner mit einem Eingangsanschluß (n+1), der mit der genannten Basis des genannten PNP-Transistors (12) verbunden ist.

3. Logische Schaltungsvorrichtung nach Anspruch 1, bei welcher der genannte NPN - Eingangstransistor (Q11) ein Multiemittertransistor ist, der eine Mehrzahl von Emittern für die genannten ersten Anschlüsse und einen Kollektor für den zweiten Anschluß hat.

4. Logische Schaltungsvorrichtung nach Anspruch 3, bei welcher der genannte Emittertransistor als Schottky - Randschichttransistor (Q11a) ausgebildet ist.

5. Logische Schaltungsvorrichtung nach Anspruch 3, bei welcher sowohl der Multiemittertransistor (Q11) als auch der genannte PNP-Transistor (Q12) in einem Isolationsbereich (15) gebildet sind.


**Revendications**

1. Dispositif à circuit logique comprenant un transistor d'entrée NPN ($Q_{11}$) possédant plusieurs premières bornes et une deuxième borne, chacune des premières bornes étant connectée à l'une de plusieurs bornes d'entrée (1-n) du dispositif à circuit logique, un transistor PNP ($Q_{12}$) dont la base est connectée à ladite deuxième borne du transistor d'entrée, dont l'émetteur est connecté à un premier potentiel d'alimentation électrique et dont le collecteur est connecté à un deuxième potentiel d'alimentation électrique, et un transistor de sortie NPN ($Q_{13}$) dont l'émetteur est connecté audit deuxième potentiel d'alimentation électrique et dont la base est connectée à ladite deuxième borne du transistor d'entrée NPN, caractérisé en ce qu'un moyen de décalage de niveau ($D_1$) est connecté entre l'émetteur du transistor PNP ($Q_{12}$) et la base du transistor de sortie NPN ($Q_{13}$).

2. Dispositif à circuit logique selon la revendication 1, comprenant en outre une borne d'entrée (n+1) qui est connectée à ladite base dudit transistor PNP ($Q_{12}$).

3. Dispositif à circuit logique selon la revendication 1, où ledit transistor d'entrée NPN ($Q_{11}$) est un transistor à multi-émetteur possédant plusieurs émetteurs au titre desdites premières bornes et un collecteur au titre de ladite deuxième borne.

4. Dispositif à circuit logique selon la revendication 3, où ledit transistor à multi-émetteur se présente sous la forme d'un transistor à barrière de Schottky ($Q_{11a}$).

5. Dispositif à circuit logique selon la revendication 3, où ledit transistor à multi-émetteur ($Q_{11}$) et ledit transistor PNP ($Q_{12}$) sont formés dans une région d'isolation (15).

## Fig. 1

## Fig. 2

1

*Fig. 3A*

*Fig. 3B*

*Fig. 4*